(19) Europäisches Patentamt
European Patent Office
Office européen des brevets

(11) **EP 4 560 862 A1**

(12) # EUROPEAN PATENT APPLICATION

(43) Date of publication:
**28.05.2025  Bulletin 2025/22**

(21) Application number: **24306872.3**

(22) Date of filing: **07.11.2024**

(51) International Patent Classification (IPC):
**H02H 7/26** *(2006.01)*      **H02H 3/30** *(2006.01)*

(52) Cooperative Patent Classification (CPC):
**H02H 3/30; H02H 7/261**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.11.2023  CN 202311502825**

(71) Applicant: **SCHNEIDER ELECTRIC INDUSTRIES SAS**
**92500 Rueil-Malmaison (FR)**

(72) Inventors:
• **ZHENG, Jiaxiang**
  **Shanghai 201203 (CN)**
• **ZHANG, Xiaoping**
  **Shanghai 201203 (CN)**
• **HAN, Xiaozhen**
  **Shanghai 201203 (CN)**
• **DENG, Yuanxun**
  **Shanghai 201203 (CN)**

(74) Representative: **Manitz Finsterwald**
**Patent- und Rechtsanwaltspartnerschaft mbB**
**Martin-Greif-Strasse 1**
**80336 München (DE)**

(54) **SAMPLING SYNCHRONIZATION METHOD FOR DIFFERENTIAL PROTECTION DEVICE, DIFFERENTIAL PROTECTION DEVICE AND SYSTEM**

(57)    A sampling synchronization method for a differential protection device is disclosed, the differential protection device is configured for being arranged at one end of a data channel as an adjusting end device, and the other end of the data channel is arranged with another differential protection device as a reference end device. The sampling synchronization method starts a sampling synchronization operation once in each adjusting end sampling cycle. The sampling synchronization operation includes: sending a first message to the reference end device; receiving a second message sent by the reference end device; determining a sampling moment deviation between the adjusting end device and the reference end device; adjusting a first adjusting end sampling moment after completion of the sampling synchronization operation based on the sampling moment deviation. Furthermore, a differential protection device and a system for differential protection are disclosed.

FIG. 1

**Description**

TECHNICAL FIELD

The present disclosure relates to the field of relay protection, and specifically to a sampling synchronization method for a differential protection device, a differential protection device, and a system for differential protection.

BACKGROUND

Differential protection is a commonly used relay protection method, which detects the current imbalance of the protected section to determine whether there is a fault in the protected section, so as to carry out the corresponding protection action, such as triggering the circuit breaker. Differential protection devices are usually installed at both ends of the protected section, and ensuring the synchronization of the sampling data collected by the differential protection devices on both sides to their respective sides is the key to the safety and reliability of differential protection. In practice, the sampling moment deviation is caused by the non-uniform clock and crystal drift of both differential protection devices.
The mainstream solution lies in sampling synchronization based on Fourier algorithms. However, sampling synchronization based on the Fourier algorithm does not provide fault recordings containing data from both sides, which makes subsequent fault analysis difficult, and fault detection generated in the presence of saturated inductors used for current sensing and monitoring affects the results of the Fourier calculations, which makes data acquisition inaccurate. Inductor detection with the aid of the Fourier algorithm requires at least one cycle of data sampling, which results in a differential protection delay of about 20 ms. In addition, after the sampled data has been Fourier-calculated and angled, additional error currents are introduced in the sampling synchronization, which reduces the protection sensitivity and the protection action time.

SUMMARY

In order to solve the above problems, the present disclosure provides a sampling synchronization method for a differential protection device, a differential protection device, and a system for differential protection, the sampling synchronization method for a differential protection device and the differential protection device and the system for differential protection are capable of achieving simpler, more accurate, and reliable sampling synchronization without the need to perform a Fourier transform on the sampled data and without the need for an external time source.
Embodiments of the present disclosure provide a sampling synchronization method for a differential protection device, wherein the differential protection device is used for being arranged at one end of a data channel as an adjusting end device, and the other end of the data channel is arranged with another differential protection device as a reference end device. The sampling synchronization method starts a sampling synchronization operation once in each adjusting end sampling cycle, ends of the adjusting end sampling cycle are adjusting end sampling moments.
The sampling synchronization operation includes: sending a first message to the reference end device, wherein the first message includes adjusting end sampling data sampled at a beginning adjusting end sampling moment of the adjusting end sampling cycle, receiving a second message sent by the reference end device, wherein the second message includes a reference end receiving moment at which the reference end device received the first message, a reference end sending moment at which the reference end device sent the second message, a first reference end sampling moment after the reference end receiving moment, and reference end sampling data sampled at the first reference end sampling moment, determining a sampling moment deviation between the adjusting end device and the reference end device based on the moment of sending the first message, the moment of receiving the second message, the reference end receiving moment, the reference end sending moment, the first reference end sampling moment, and a first adjusting end sampling moment after the beginning adjusting end sampling moment, and adjusting a first adjusting end sampling moment after completion of the sampling synchronization operation based on the sampling moment deviation.
According to embodiments of the present disclosure, the determining a sampling moment deviation between the adjusting end device and the reference end device includes: calculating a channel delay of the data channel based on the following equation:

$$T_d = (T_2'-T_1'-(T_2-T_1))/2$$

and calculating the sampling moment deviation based on the following equation:

$$T_o = T_2' - T_d-(T_2-T_{B2}) -T_{A2}$$

wherein $T_1'$ is the moment of sending the first message, $T_1$ is the reference end receiving moment, $T_2$ is the reference end sending moment, $T_2'$ is the moment of receiving the second message, $T_{B2}$ is the first reference end sampling moment, and $T_{A2}$ is the first adjusting end sampling moment after the beginning adjusting end sampling moment.

According to embodiments of the present disclosure, a determinant of the reference end sending moment includes a predetermined message processing time period.

According to embodiments of the present disclosure, in response to a time interval between the reference end receiving moment and the first reference end sampling moment being greater than the message processing time period, the reference end sending moment is the first reference end sampling moment; and in response to a time interval between the reference end receiving moment and the first reference end sampling moment being less than or equal to the message processing time period, the reference end sending moment is the moment when the message processing time period is completed.

According to embodiments of the present disclosure, the adjusting a first adjusting end sampling moment after completion of the sampling synchronization operation based on the sampling moment deviation includes: setting an adjustment step size and comparing the adjustment step size with the sampling moment deviation, if the adjustment step size is less than the sampling moment deviation, adjusting the first adjusting end sampling moment after completion of the sampling synchronization operation by the adjustment step size, and if the adjustment step size is greater than or equal to the sampling moment deviation, adjusting the first adjusting end sampling moment after completion of the sampling synchronization operation by the sampling moment deviation to eliminate the sampling moment deviation.

According to embodiments of the present disclosure, the adjusting a first adjusting end sampling moment after completion of the sampling synchronization operation based on the sampling moment deviation includes: setting an adjustment step size and a deviation threshold, and comparing the sampling moment deviation with the deviation threshold, the if the sampling moment deviation is greater than or equal to the deviation threshold, adjusting the first adjusting end sampling moment after completion of the sampling synchronization operation by the adjustment step size, and if the sampling moment deviation is less than the deviation threshold, the first adjusting end sampling moment after completion of the sampling synchronization operation is not adjusted.

According to embodiments of the present disclosure, the adjustment step size is less than 10 $\mu$s.

According to embodiments of the present disclosure, the deviation threshold is less than 10 $\mu$s.

Embodiments of the present disclosure provide a differential protection device including: at least one processor; and at least one memory in which is stored an executable program which, when the executable program is executed by the at least one processor, performs a sampling synchronization method according to the present disclosure.

Embodiments of the present disclosure provide a system for differential protection including a first differential protection device and a second differential protection device arranged at two ends of the system, respectively. The first differential protection device is a differential protection device according to the present disclosure. The second differential protection device is a differential protection device that serves as a reference end device according to the present disclosure, wherein the reference end device is capable of receiving a first message at a reference end receiving moment and sending a second message at a reference end sending moment.

The sampling synchronization method according to embodiments of the present disclosure acquires raw sampling data of the present side and the opposite side at the same absolute moment by synchronizing the sampling moment of the differential protection device of one side with that of the differential protection device of the other side, without transforming the sampling data. Further, in accordance with the sampling synchronization method according to embodiments of the present disclosure, the sending and receiving of the sampling data of the present side and the sampling synchronization operation of the present side are combined, simplifying the implementation of the sampling synchronization method and the design of the differential protection device. Moreover, because the sampling synchronization operation is initiated once in each adjusting end sampling cycle, it makes it possible to monitor and ensure the sampling synchronization in real time and continuously throughout the differential protection process. In addition, the sampling synchronization method according to embodiments of the present disclosure does not require an external time source independent of the adjusting end device and the reference end device, simplifying the implementation of the sampling synchronization method and the design of the differential protection device.

BRIEF DESCRIPTION OF DRAWINGS

In order to illustrate the technical scheme of the embodiments of the present disclosure more clearly, the accompanying drawings required to be used in the description of the embodiments will be briefly described below. Obviously, the accompanying drawings in the description below are only exemplary embodiments of the present disclosure, and other accompanying drawings can be obtained according to these accompanying drawings without creative work for persons having ordinary skill in the art.

FIG. 1 schematically illustrates a flowchart of a sampling synchronization method and a sampling synchronization operation for a differential protection device according to an embodiment of the present disclosure;

FIG. 2 schematically illustrates, in a message propagation example diagram, a method of calculating a sampling moment deviation according to an embodiment of the present disclosure;

FIG. 3 illustrates a schematic diagram of a differential protection device according to an embodiment of the present disclosure;

FIG. 4 illustrates a schematic diagram of a system for differential protection according to an embodiment of the present disclosure.

DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

In the present specification and the accompanying drawings, substantially same or similar steps and elements are represented by the same or similar reference numerals, and repeated descriptions of these steps and elements will be omitted. Meanwhile, the terms "first," "second," etc., which are used in the description and the claims of the present application for disclosure, are not intended to indicate any sequence, amount or importance, but for distinguishing various components.

Unless otherwise defined, all technical and scientific terms used herein have the same meanings as commonly understood by those skilled in the art of the present disclosure. The terms used herein are only for the purpose of describing the embodiments of the disclosure and are not intended to limit the disclosure.

To facilitate the description of the present disclosure, concepts related to the present disclosure are introduced below.

Differential protection: a type of localized protection for protected sections of a power system, based on a comparison of the currents at the two ends of the protected section. Differential protection is based on Kirchhoff s current law, where the currents at the ends of the protected section deviate significantly from equilibrium in the event of a fault.

Data channel: e.g. a fiber optic channel. The local differential protection device sends local sampling data to the opposite side differential protection device and receives the opposite side sampling data with the aid of the data channel.

Clock: the differential protection device performs sampling based on an internal clock.

Sampling moment: the differential protection device performs sampling at the relative sampling moment of present side respectively, due to the possible clock inconsistency of the differential protection devices on both sides, resulting in the absolute sampling moments of the differential protection devices on both sides being inconsistent.

Adjusting end device and reference end device: According to embodiments of the present disclosure, the differential protection device on both sides are respectively provided as the adjusting end device and reference end device in the sampling synchronization method, the reference end device does not carry out sampling synchronization adjustment, and its sampling moment is used as a reference, and the adjusting end device adjusts the sampling moment of present side based on the sampling moment deviation, so as to realize that the sampling moments of the adjusting end device are synchronized with the sampling moments of the reference end device.

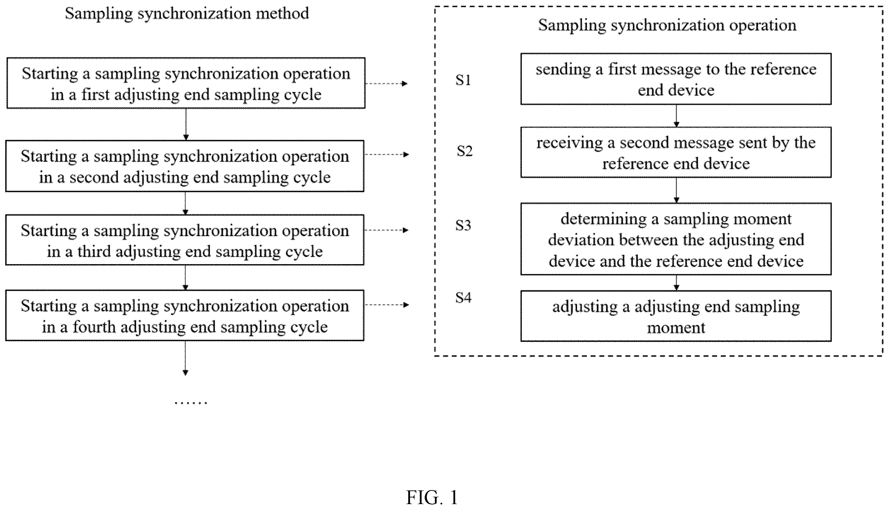

FIG. 1 schematically illustrates a flowchart of a sampling synchronization method and a sampling synchronization operation for a differential protection device according to an embodiment of the present disclosure.

As shown on the left side of FIG. 1, a sampling synchronization method for a differential protection device according to an embodiment of the present disclosure can start a sampling synchronization operation in each adjusting end sampling cycle (e.g., a first adjusting end sampling cycle, a second adjusting end sampling cycle, a third adjusting end sampling cycle, etc.) to ensure that each sampling moment of a differential protection device arranged as an adjusting end device at one end of the data channel, i.e., the adjusting end sampling moment is associated with one sampling synchronization operation. Thus, continuous monitoring and adjustment for synchronization of the sampling synchronization method according to embodiments of the present disclosure is achieved.

The ends of the adjusting end sampling cycle can, for example, be adjusting end sampling moments, wherein the beginning end can, for example, be an adjusting end sampling moment, hereinafter also referred to as a beginning adjusting end sampling moment, and the ending end can be another adjusting end sampling moment. One or more adjusting end sampling moments can, for example, be spanned between the ending end and the beginning end.

Since each adjusting end sampling moment corresponds to an adjusting end sampling cycle, and the sampling synchronization operation performed in the adjusting end sampling cycle may not necessarily be completed within the adjusting end sampling interval between successive adjusting end sampling moments of each other, the adjusting end sampling cycles can, for example, overlap each other in time. The order of the arrows illustrated on the left side of FIG. 1 indicates only the order of occurrence of the adjusting end sampling cycles, and does not mean that, for example, the second adjusting end sampling cycle is only entered after the first adjusting end sampling cycle has ended.

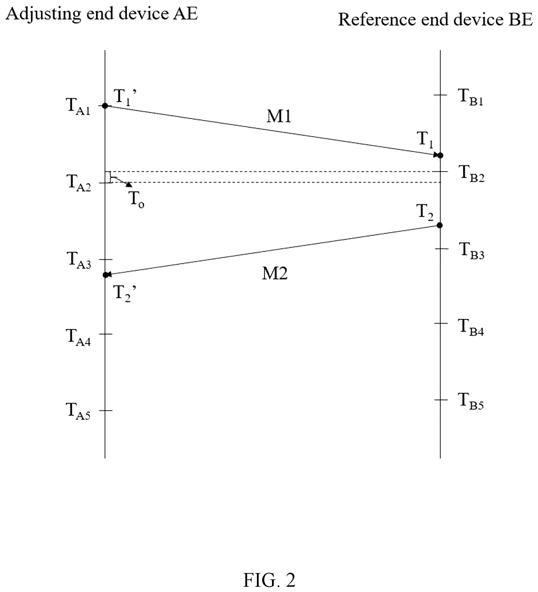

As shown on the right side of FIG. 1, the sampling synchronization operation started and executed in each adjusting end sampling cycle according to embodiments of the present disclosure can, for example, include four steps. The sampling synchronization operation is specifically described below in connection with FIG. 2.

In the first step S 1, a first message can be sent, for example, to the reference end device, which schematically corresponds to the process shown by the solid line with arrows with the $T_1'$ moment as an endpoint in FIG. 2.

The first message can, for example, include adjusting end sampling data sampled at a beginning adjusting end sampling moment of the adjusting end sampling cycle. Optionally, the first message further includes this beginning adjusting end sampling moment. Optionally, the first message further includes data that may be required, such as a sampling synchronization instruction or a message verification message.

Preferably, the moment of sending the first message is that beginning adjusting end sampling moment. Optionally, the moment of sending the first message is later than the beginning adjusting end sampling moment.

In the second step S2, a second message sent by the reference end device can be received, for example, which schematically corresponds to the process shown in FIG. 2 with the solid line with an arrow as an endpoint at the moment $T_2'$.

The second message can include, for example, a reference end receiving moment at which the reference end device receives the first message, a reference end sending moment at which the reference end device sent the second message, a first reference end sampling moment after the reference end receiving moment, and reference end sampling data sampled at the first reference end sampling moment.

The determining factor for the reference end sending moment can for example include a predetermined message processing time period.

After receiving the first message, the reference end device can process, e.g., parse, the first message within a predetermined message processing time period to obtain adjusting end sampling data in the first message for differential protection analysis, and optionally can obtain a sampling synchronization command to return corresponding data in a second message. The predetermined message processing time period can be specified by the user on demand so that the message processing can be completed within the message processing time period regardless of the length of the first message.

Since the second message needs to include reference end sampling data sampled by the reference end device at a reference end sampling moment, the reference end necessarily spans a reference end sampling moment from the reference end receiving moment at which the first message is received to the reference end sending moment at which the second message is sent. This reference end sampling moment is preferably a first reference end sampling moment after this reference end receiving moment.

Preferably, in the case where the time interval between the reference end receiving moment and the first reference end sampling moment is greater than the above described message processing time period, the reference end sending moment is the first reference end sampling moment. In the case where the time interval between the reference end receiving moment and the first reference end sampling moment is less than or equal to the above message processing time period, the reference end sending moment is the moment when the message processing time period is completed.

Optionally, the reference end sending moment is the first reference end sampling moment after the reference end receiving moment, independent of the message processing time period. This idea is based on the fact that the reference end device processes the first message in order to obtain the adjusting end sampling data, a process which does not affect the sampling synchronization relationship between the adjusting end and the reference end. The reference end device can send a second message containing the reference end sampling data after sampling at the first reference end sampling moment, regardless of whether the first message has been processed or not. In this manner, the duration of the sampling synchronization operation can be shortened, for example. However, the reliability of the sampling synchronization method can be reduced by returning the second message without considering whether the first message has been processed or not, and without obtaining message verification information or message integrity information that can be included in the first message.

In the third step S3, a sampling moment deviation between the adjusting end device and the adjusting end device can be determined, for example, based on the moment of sending the first message, the moment of receiving the second message, the reference end receiving moment, the reference end sending moment, the first reference end sampling moment after the reference end receiving moment, and the first adjusting end sampling moment after the beginning adjusting end sampling moment. Wherein the adjusting end device obtains the moment of sending the first message and the first adjusting end sampling moment after the beginning adjusting end sampling moment on the present side, and the other moments involved in the calculation are obtained from the second message received in the second step S2.

In the fourth step S4, a first adjusting end sampling moment after completion of the sampling synchronization operation can be adjusted, for example, based on the calculated sampling moment deviation. In other words, after calculating the latest sampling moment deviation between the adjusting end device and the reference end device, the upcoming adjusting end sampling moment is adjusted so that the sampling moment deviation is reduced.

As described above, the sampling synchronization operation performed in the adjusting end sampling cycle is not necessarily completed within the adjusting end sampling interval between successive adjusting end sampling moments of each other, and therefore, after the latest sampling moment deviation is calculated in the sampling synchronization operation, the first adjusting end sampling moment after completion of the sampling synchronization operation is adjusted based on the sampling moment deviation. For example, if the completion of the sampling synchronization operation for the first adjusting end sampling cycle will be followed by a third adjusting end sampling cycle, the beginning adjusting end sampling moment for the third adjusting end sampling cycle is adjusted based on the sampling moment deviation calculated in the first adjusting end sampling cycle.

The adjustment of the adjusting end sampling moment can include, for example, setting an adjustment step size length and comparing this adjustment step size length with a calculated sampling moment deviation. When the adjustment step size is less than the sampling moment deviation, a first adjusting end sampling moment after completion of the sampling synchronization operation can be adjusted by the adjustment step size, i.e., so that the sampling moment deviation reduces the adjustment step size. When the adjustment step size is greater than or equal to the sampling moment deviation, for example, the sampling moment deviation can be adjusted by the adjustment step size directly to the first adjusting end sampling moment after the sampling synchronization operation is completed, so that the sampling moment deviation is eliminated. In this manner, the sampling synchronization accuracy can be substantially improved, thereby improving the accuracy of the differential protection.

Alternatively, the adjusting of the adjusting end sampling moments can include, for example, setting an adjustment step size and a deviation threshold, and comparing the sampling moment deviation to the deviation threshold. When the sampling moment deviation is greater than or equal to the deviation threshold, a first adjusting end sampling moment after the sampling synchronization operation is completed is adjusted with the adjustment step size. When the sampling moment deviation is less than the deviation threshold, the adjusting end device can be considered to have been synchronized with the reference end device, and therefore the first adjusting end sampling moment after completion of the sampling synchronization operation is not adjusted. In this way, a higher sampling synchronization accuracy can be ensured, and the calculation overhead of the differential protection device can be reduced at the same time.

According to an embodiment of the present disclosure, the adjustment step size is optionally less than 10 $\mu$s, preferably 5 $\mu$s, 2 $\mu$s, and other suitable adjustment step size values can be thought of. The smaller the adjustment step size, the higher the synchronization accuracy.

According to an embodiment of the present disclosure, the deviation threshold is optionally less than 10 $\mu$s, preferably 5 $\mu$s, 2 $\mu$s, and other suitable deviation thresholds can be thought of.

In accordance with the sampling synchronization method according to embodiments of the present disclosure, the sampling moment deviation is gradually reduced in each adjusting end sampling cycle by an adjustment step size, ensuring that the adjustment amplitude of each sampling moment is small, so that the deviation of sampling data successive to each other, for example, the change in the phase angle of the current, will not be very large, and the erroneous protection action is effectively avoided.

Optionally, the adjusting end sampling data and the reference end sampling data are applied to the differential protection only after the adjusting end device is synchronized to the reference end device.

The sampling synchronization method according to embodiments of the present disclosure obtains raw sampling data of the present side and the opposite side sampled at the same absolute moment by synchronizing the sampling moment of the differential protection device on one side with that of the other differential protection device on the other side, making it possible to carry out recording of fault waveforms of both sides at the moment of the fault, and to utilize the raw data for applications such as monitoring of inductors in the differential protection, which makes the analysis of the problem easier and more intuitive. It makes the problem analysis simpler and more intuitive, and the operation speed faster.

Further, in accordance with the sampling synchronization method according to embodiments of the present disclosure, the sending and receiving of the sampling data of the present side are combined with the sampling synchronization operation of the present side, instead of sending the sampling synchronization message separately from the transmission of the sampling data, which reduces the type and frequency of data to be transmitted, and simplifies the implementation of the sampling synchronization method and the design of the differential protection device. In addition, since the sampling synchronization operation is initiated once in each adjusting end sampling cycle, it makes it possible to monitor and ensure the sampling synchronization in real time and continuously throughout the differential protection process, to satisfy the requirements of long-term synchronization accuracy and uniform sampling, and consequently to improve the reliability and accuracy of the differential protection as well.

Furthermore, the sampling synchronization method according to embodiments of the present disclosure does not require a third clock (i.e., a common external time source) independent of the adjusting end device and the reference end device, and only requires a sampling synchronization operation to be performed during the adjusting end sampling cycle, i.e., to perform the sending and receiving of messages, and the calculations in the differential protection device set up as the adjusting end device, to synchronize the sampling moment of the adjusting end device with the sampling moment of the reference end device. This simplifies the implementation of the sampling synchronization method and the design of the differential protection device.

FIG. 2 schematically illustrates, in a message propagation example diagram, a method of calculating a sampling moment deviation according to an embodiment of the present disclosure.

As shown in FIG. 2, the adjusting end device AE performs sampling at the adjusting end sampling moments $T_{A1}$, $T_{A2}$, $T_{A3}$, $T_{A4}$, $T_{A5}$, respectively, and the reference end device BE performs sampling at the reference end sampling moments $T_{B1}$, $T_{B2}$, $T_{B3}$, $T_{B4}$, $T_{B5}$, respectively, and there is a sampling moment deviation between the adjusting end sampling moments and the reference end sampling moments. For the sake of clarity, FIG. 2 only exemplarily illustrates an adjusting end sampling cycle with the $T_{A1}$ moment as the beginning adjusting end sampling moment, and the two ends of the adjusting end sampling cycle are the $T_{A1}$ moment and the $T_{A4}$ moment.

As shown in FIG. 2, the adjusting end device AE sends a first message M1 to the reference end device BE at the moment $T_1'$ which can be, for example, the moment $T_{A1}$, and receives a second message M2 sent by the reference end device BE at the moment $T_2'$ as shown in FIG. 2. The reference end device BE receives the first message M1 at the reference end receiving moment $T_1$ and sends the second message M2 at the reference end sending moment $T_2$, which includes the reference end receiving moment $T_1$, the reference end sending moment $T_2$, a first reference end sampling moment $T_{B2}$ after the reference end receiving moment $T_1$ of the reference end device BE, and reference end sampling data sampled at the first reference end sampling moment $T_{B2}$. For clarity, the subscript with "A" or "B" indicates the sampling moment of the adjusting end device and the reference end device, and the subscript without "A" or "B" indicates the moment when the adjusting end device and the reference end device receive and send messages. In addition, the superscript without " ' " indicates the moment on the present side of the reference end device BE, and the superscript with " ' " indicates the moment on the present side of the adjusting end device AE.

After receiving the second message M2, a channel delay $T_d$ of the data channel can be calculated, for example, at the adjusting end device AE side based on the following equation:

$$T_d = (T_2' - T_1' - (T_2 - T_1))/2 \qquad (1)$$

Wherein Equation 1 is premised on the equality of channel delays from the adjusting end device AE to the reference end device BE and from the reference end device BE to the adjusting end device AE.

After the channel delay $T_d$ has been calculated, the sampling moment deviation $T_o$ can be calculated, for example, based on the following equation:

$$T_o = T_2' - T_d - (T_2 - T_{B2}) - T_{A2} \qquad (2)$$

Where $T_{A2}$ is the first adjusting end sampling moment after the beginning adjusting end sampling moment $T_{A1}$ of the involved adjusting end sampling cycle. In the embodiment shown, $T_o$ represents the deviation between the adjusting end sampling moment $T_{A2}$ and the reference end sampling moment $T_{B2}$.

In the case of $T_o < 0$, the adjusting end sampling moment $T_{A2}$ is ahead of the reference end sampling moment $T_{B2}$, and in the case of $T_o > 0$, the adjusting end sampling moment $T_{A2}$ lags behind the reference end sampling moment $T_{B2}$.

According to the method for calculating the sampling moment deviation of the embodiment of the present disclosure, instead of directly calculating the moment of the present side of the reference end device BE from the moment of the present side of the adjusting end device AE, it is calculated by the adjusting end device AE based on the moment of the present side and the moment difference of the reference end device BE (e.g., $(T_2 - T_1)$ in Equation 1 and $(T_2 - T_{B2})$ in Equation 2), thereby efficiently avoiding a problem of inconsistency in recorded absolute moments caused by an inconsistency in the clocks of the adjusting end device AE and the reference end device BE. For this reason, the second message can also directly include the above moment difference of the reference end device BE.

As shown in Fig. 2, after calculating the sampling moment deviation $T_o$, the first adjusting end sampling moment, i.e., $T_{A4}$ moment, after the completion of the sampling synchronization operation shown in the sampling synchronization operation can be adjusted based on the sampling moment deviation.

The method of calculating the sampling moment deviation according to embodiments of the present disclosure makes it possible to calculate the channel delay, the sampling moment deviation, and adjust the upcoming adjusting end sampling moments within a single sampling synchronization operation and in a simple, i.e., based on a plurality of moments, manner, without the need for transforming the sampled data.

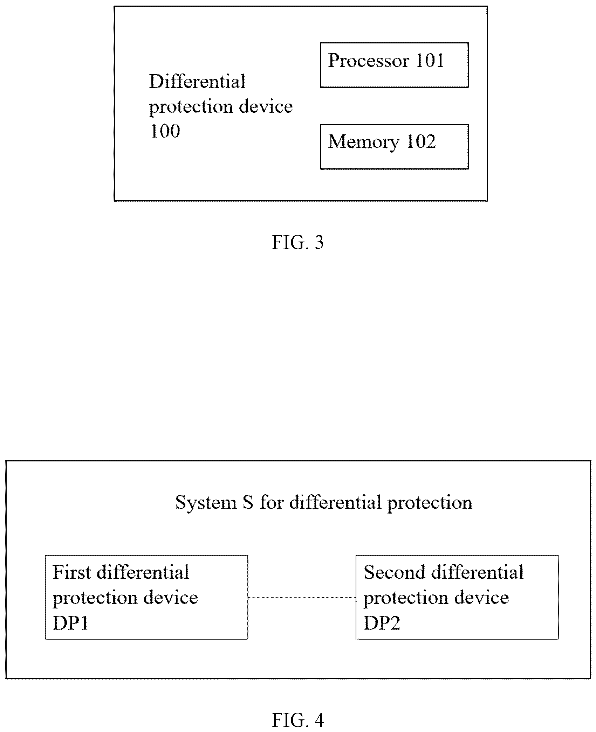

FIG. 3 illustrates a schematic diagram of a differential protection device 100 according to embodiments of the present disclosure.

As shown in FIG. 3, the differential protection device 100 includes one or more processors 101, and one or more memories 102. Wherein the one or more memories 102 have an executable program stored therein, which when executed by the processor(s) 101 performs the sampling synchronization method as described above. The specific description of the sampling synchronization method as described above applies equally to the differential protection device 100.

The processor in embodiments of the present disclosure can be an integrated circuit chip with signal processing capabilities. The processor can be a general-purpose processor, a digital signal processor (DSP), an application-specific integrated circuit (ASIC), an off-the-shelf programmable gate array (FPGA) or other programmable logic device, a discrete gate or transistor logic device, or a discrete hardware component. They can implement or perform various methods, steps, and logic block diagrams of the disclosure in embodiments of the present application. The general-purpose processor can be a microprocessor or the processor can also be any conventional processor, etc., and can be of X86 architecture or ARM architecture.

FIG. 4 illustrates a schematic diagram of a system S for differential protection according to embodiments of the present disclosure.

As shown in FIG. 4, the system S for differential protection can include a first differential protection device DP1 and a second differential protection device DP2 arranged at each end of the system.

The first differential protection device DP1 can for example be a differential protection device according to embodiments of the present disclosure. The second differential protection device DP2 can, for example, be a differential protection device as a reference end device according to embodiments of the present disclosure, wherein the reference end device is capable of receiving a first message at the reference end receiving moment and sending a second message at the reference end sending moment.

The specific description of the sampling synchronization method and the differential protection device above also applies to the system S used for differential protection.

In general, the various example embodiments of the disclosure can be implemented in hardware or special purpose circuits, software, firmware, logic or any combination thereof. Certain aspects can be implemented in hardware, while other aspects can be implemented in firmware or software which can be executed by a controller, microprocessor or other computing device. While aspects of embodiments of the present disclosure are illustrated or described as block diagrams, flow charts, or using some other graphical representation, it is understood that the blocks, apparatus, systems, techniques or methods described herein can be implemented in, as nonlimiting examples, hardware, software, firmware, special purpose circuits or logic, general purpose hardware or controller or other computing devices, or some combination thereof.

The example embodiments of the present disclosure described in detail above are merely illustrative, and are not limiting. It will be understood by those skilled in the art that various modifications and combinations of these embodiments or features thereof can be made without departing from the principles of the present disclosure, such modifications shall fall within the scope of the present disclosure.

**Claims**

1.  A sampling synchronization method for a differential protection device, wherein the differential protection device is configured for being arranged at one end of a data channel as an adjusting end device, and the other end of the data channel is arranged with another differential protection device as a reference end device, wherein

    the sampling synchronization method starts a sampling synchronization operation once in each adjusting end sampling cycle, ends of the adjusting end sampling cycle are adjusting end sampling moments; and
    the sampling synchronization operation comprises:

    sending a first message to the reference end device, wherein the first message comprises adjusting end sampling data sampled at a beginning adjusting end sampling moment of the adjusting end sampling cycle,
    receiving a second message sent by the reference end device, wherein the second message comprises a reference end receiving moment at which the reference end device received the first message, a reference end sending moment at which the reference end device sent the second message, a first reference end sampling moment after the reference end receiving moment, and reference end sampling data sampled at the first reference end sampling moment,
    determining a sampling moment deviation between the adjusting end device and the reference end device based on the moment of sending the first message, the moment of receiving the second message, the reference end receiving moment, the reference end sending moment, the first reference end sampling moment, and a first adjusting end sampling moment after the beginning adjusting end sampling moment, and
    adjusting a first adjusting end sampling moment after completion of the sampling synchronization operation based on the sampling moment deviation.

2.  The sampling synchronization method according to claim 1, wherein the determining a sampling moment deviation between the adjusting end device and the reference end device comprises:

calculating a channel delay of the data channel based on the following equation:

$$T_d = (T_2' - T_1' - (T_2 - T_1))/2$$

and calculating the sampling moment deviation based on the following equation :

$$T_o = T_2' - T_d - (T_2 - T_{B2}) - T_{A2}$$

wherein $T_1'$ is the moment of sending the first message, $T_1$ is the reference end receiving moment, $T_2$ is the reference end sending moment, $T_2'$ is the moment of receiving the second message, $T_{B2}$ is the first reference end sampling moment, and $T_{A2}$ is the first adjusting end sampling moment after the beginning adjusting end sampling moment.

3. The sampling synchronization method according to claim 1, wherein
a determinant of the reference end sending moment comprises a predetermined message processing time period.

4. The sampling synchronization method according to claim 3, wherein

in response to a time interval between the reference end receiving moment and the first reference end sampling moment being greater than the message processing time period, the reference end sending moment is the first reference end sampling moment; and
in response to a time interval between the reference end receiving moment and the first reference end sampling moment being less than or equal to the message processing time period, the reference end sending moment is the moment when the message processing time period is completed.

5. The sampling synchronization method according to claim 1, wherein the adjusting a first adjusting end sampling moment after completion of the sampling synchronization operation based on the sampling moment deviation comprises:

setting an adjustment step size and comparing the adjustment step size with the sampling moment deviation,
if the adjustment step size is less than the sampling moment deviation, adjusting the first adjusting end sampling moment after completion of the sampling synchronization operation by the adjustment step size, and
if the adjustment step size is greater than or equal to the sampling moment deviation, adjusting the first adjusting end sampling moment after completion of the sampling synchronization operation by the sampling moment deviation to eliminate the sampling moment deviation.

6. The sampling synchronization method according to claim 1, wherein the adjusting a first adjusting end sampling moment after completion of the sampling synchronization operation based on the sampling moment deviation comprises:

setting an adjustment step size and a deviation threshold, and comparing the sampling moment deviation with the deviation threshold,
if the sampling moment deviation is greater than or equal to the deviation threshold, adjusting the first adjusting end sampling moment after completion of the sampling synchronization operation by the adjustment step size, and
if the sampling moment deviation is less than the deviation threshold, the first adjusting end sampling moment after completion of the sampling synchronization operation is not adjusted.

7. The sampling synchronization method according to claim 5, wherein
the adjustment step size is less than 10 $\mu$s.

8. The sampling synchronization method according to claim 6, wherein
the deviation threshold is less than 10 $\mu$s.

9. A differential protection device comprising:

at least one processor; and

at least one memory in which is stored an executable program which, when the executable program is executed by the at least one processor, performs a sampling synchronization method in any one of claims 1-8.

10. A system for differential protection comprising a first differential protection device and a second differential protection device arranged at two ends of the system, respectively, wherein

the first differential protection device is a differential protection device according to claim 9,
the second differential protection device is a differential protection device as a reference end device according to any one of claims 1 to 8, wherein the reference end device is capable of receiving a first message at a reference end receiving moment and sending a second message at a reference end sending moment.

Sampling synchronization method

Sampling synchronization operation

| Starting a sampling synchronization operation in a first adjusting end sampling cycle | ⇢ | S1 | sending a first message to the reference end device |

| Starting a sampling synchronization operation in a second adjusting end sampling cycle | ⇢ | S2 | receiving a second message sent by the reference end device |

| Starting a sampling synchronization operation in a third adjusting end sampling cycle | ⇢ | S3 | determining a sampling moment deviation between the adjusting end device and the reference end device |

| Starting a sampling synchronization operation in a fourth adjusting end sampling cycle | ⇢ | S4 | adjusting a adjusting end sampling moment |

......

FIG. 1

EP 4 560 862 A1

FIG. 2

Differential
protection device
100

Processor 101

Memory 102

FIG. 3

System S for differential protection

First differential
protection device
DP1

Second differential
protection device
DP2

FIG. 4

## EUROPEAN SEARCH REPORT

Europäisches
Patentamt
European
Patent Office
Office européen
des brevets

**Application Number**

EP 24 30 6872

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 231 472 A2 (SCHNEIDER ELECTRIC IND SAS [FR]) 23 August 2023 (2023-08-23) * abstract * * paragraph [0018] - paragraph [0050] * * figures 1-4 * | 1-10 | INV. H02H7/26 H02H3/30 |
| A | US 2011/063766 A1 (KASZTENNY BOGDAN Z [CA] ET AL) 17 March 2011 (2011-03-17) * abstract * * figures 2-4 * * paragraph [0038] - paragraph [0047] * | 1-10 | |
| A | CN 112 993 949 A (XUJI GROUP CORP; XUJI ELECTRIC CO LTD; XUCHANG XJ SOFTWARE TECHNOLOGY) 18 June 2021 (2021-06-18) * abstract * * figure 1 * * paragraph [0004] - paragraph [0013] * | 1-10 | |

**TECHNICAL FIELDS SEARCHED (IPC)**

H02H

The present search report has been drawn up for all claims

| Place of search | Date of completion of the search | Examiner |
|---|---|---|
| Munich | 14 April 2025 | Operti, Antonio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 6872

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2025

| Patent document cited in search report | | | Publication date | Patent family member(s) | | | Publication date |
|---|---|---|---|---|---|---|---|
| EP 4231472 | | A2 | 23-08-2023 | CN | 116560456 | A | 08-08-2023 |
| | | | | EP | 4231472 | A2 | 23-08-2023 |
| | | | | US | 2023246438 | A1 | 03-08-2023 |
| US 2011063766 | | A1 | 17-03-2011 | BR | 112012005746 | A2 | 23-02-2016 |
| | | | | CA | 2771295 | A1 | 24-03-2011 |
| | | | | ES | 2391861 | A1 | 30-11-2012 |
| | | | | US | 2011063766 | A1 | 17-03-2011 |
| | | | | US | 2012162843 | A1 | 28-06-2012 |
| | | | | WO | 2011035057 | A2 | 24-03-2011 |
| | | | | ZA | 201200539 | B | 27-03-2013 |
| CN 112993949 | | A | 18-06-2021 | NONE | | | |

EPO FORM P0459

For more details about this annex : see Official Journal of the European Patent Office, No. 12/82